# FASCICULE DE BREVET EUROPEEN

(11) **EP 1 880 588 B1**
(45) Date de publication et mention de la délivrance du brevet: **14.07.2010**
(21) Numéro de dépôt: 06707911.1
(22) Date de dépôt: 30.01.2006
(51) Int. Cl.: H05K 7/14

(54) **SUPPORT DE FIXATION POUR UN EQUIPEMENT EMBARQUE DANS UN AERONEF**
BEFESTIGUNGSELEMENT FÜR EIN GERÄT AN BORD EINES LUFTFAHRZEUGES
SUPPORT FOR FIXING A PIECE OF EQUIPMENT ON BOARD AN AIRCRAFT

(30) Priorité: 28.01.2005 FR 0500878
(43) Date de publication de la demande: 23.01.2008
(73) Titulaire: SAGEM Défense Sécurité, 75015 Paris (FR)
(72) Inventeur: GIORGIO, Alain, F-95490 Vaureal (FR); BAYET, Philippe, F-75015 Paris (FR)
(74) Mandataire: Texier, Christian
(86) Numéro de dépôt international: PCT/EP2006/050535
(87) Numéro de publication internationale: WO 2006/082178

(56) Documents cités:
- FR-A- 2 787 282
- GB-A- 1 079 367
- GB-A- 1 274 311

## Description

L'invention concerne le domaine des équipements embarqués à bord d'aéronefs.

Elle concerne l'installation des équipements radioélectriques embarqués, tels que des équipements de communication ou de navigation.

GB 1274311 A décrit un support de fixation pour un équipement embarqué à bord d'aéronef.

Une préoccupation dans le domaine de l'aéronautique concerne l'encombrement des équipements. Les équipements embarqués requièrent généralement d'être installés dans des espaces réduits.

C'est pourquoi, des normes s'appliquant aux équipements et au matériel d'installation ont été établies de manière à minimiser l'espace occupé par les équipements.

Les équipements peuvent être insérés dans des baies ou sur des racks fixés rigidement à la structure de l'avion.

Les équipements peuvent également être installés dans des compartiments ménagés sous le plancher de la cabine.

Les baies ou racks ou les compartiments et les équipements sont munis de moyens de raccordement électriques compacts. Ces moyens de raccordement électriques compacts comprennent généralement une embase et une fiche. Lorsqu'un équipement est inséré dans une baie, sur un rack ou dans un compartiment, la fiche vient en prise dans l'embase. L'embase dispose de moyens de guidage pour guider la fiche lors de l'insertion ou de l'extraction de l'équipement. En outre, l'embase ou la fiche est montée flottante de manière à permettre le guidage et la mise en prise.

Les baies ou racks ou les compartiments comprennent également des moyens de verrouillage pour immobiliser l'équipement dans la baie ou sur le rack ou dans le compartiment.

Cependant, ce type d'installation est mal adapté à certains équipements de navigation.

En effet, certains équipements de navigation, tels que par exemple des équipements de mesure inertielle, requièrent d'être positionnés de manière précise par rapport au repère de l'avion. Ces équipements requièrent typiquement d'être installés avec une erreur de positionnement maximale de l'ordre de quelques dixièmes de milliradian. L'installation des équipements dans des baies ou racks ou dans des compartiments ne permet généralement pas d'atteindre une telle précision, compte tenu des tolérances d'assemblage de l'équipement sur la baie ou le rack ou dans le compartiment.

En outre, les équipements de navigation requièrent d'être fixés de manière rigide à la structure de l'avion.

Par ailleurs, les normes définissent l'effort devant être exercé pour connecter les moyens de raccordement électriques. La connexion de la fiche dans l'embase requière typiquement un effort d'enfichage de l'ordre de 450 N. Un tel effort est difficile à exercer pour un opérateur, compte tenu notamment de la faible accessibilité de l'équipement dans les baies, les racks ou les compartiments.

Un problème résolu par l'invention est de permettre un positionnement précis des équipements embarqués dans les aéronefs.

Ce problème est résolu dans le cadre de la présente invention grâce à un support de fixation pour un équipement embarqué dans un aéronef, comprenant une partie fixe, une partie mobile, et des moyens de liaison entre la partie fixe et la partie mobile, la partie mobile comprenant des moyens de raccordement électriques destinés à être mis en prise avec des moyens de raccordement électriques complémentaires de l'équipement, les moyens de liaison étant agencés de sorte que la partie mobile est déplaçable par rapport à la partie fixe entre une position ouverte permettant de disposer l'équipement sur la partie fixe, et une position fermée, le déplacement de la partie mobile de la position ouverte à la position fermée provoquant la mise en prise des moyens de raccordement électriques de la partie mobile et de l'équipement.

Le support de l'invention permet de positionner de manière précise l'équipement sur la partie fixe, et une fois l'équipement positionné, de le raccorder électriquement.

En outre, les moyens de liaison permettent de guider les moyens de raccordement électrique l'un par rapport à l'autre lors de leur mise en prise.

Le support peut avantageusement présenter l'une des caractéristiques suivantes :
- les moyens de liaison entre la partie fixe et la partie mobile comprennent des moyens de guidage de la partie fixe par rapport à la partie mobile,
- les moyens de guidage sont rectilignes,
- les moyens de guidage comprennent au moins un rail,
- les moyens de liaison entre la partie fixe et la partie mobile sont adaptés pour permettre un coulissement de la partie mobile sur la partie fixe,
- les moyens de raccordement électrique de la partie mobile comprennent des moyens pour guider les moyens de raccordement de l'équipement lors de leur mise en prise,
- la partie fixe comprend des plots de positionnement de l'équipement sur la partie fixe, sur lesquels l'équipement peut venir en appui,
- la partie fixe comprend des pions destinés à être insérés dans des orifices de l'équipement pour positionner l'équipement sur le support,
- l'équipement est verrouille en position sur les plots au moyen de vis,
- le support comprend au moins un bras apte à être actionné pour entraîner, par effet de levier, le déplacement de la partie mobile par rapport à la partie fixe,
- le support comprend un premier axe et un deuxième axe, le bras étant apte à être monté rotatif par rapport à la partie fixe ou à l'équipement par l'intermédiaire du premier axe et étant apte à être monté rotatif par rapport à la partie mobile par l'intermédiaire du deuxième axe,
- le premier axe est apte à coulisser par rapport à la partie fixe ou par rapport à l'équipement,
- la partie fixe comprend une encoche ou une ouverture dans laquelle le premier axe peut coulisser,
- le bras est monté de manière permanente sur l'une des parties fixe ou mobile,
- le bras est monté de manière amovible sur l'une des parties fixe ou mobile de sorte qu'il peut être retiré lorsque la partie mobile est en position fermée,
- le support comprend des moyens pour verrouiller la partie mobile sur la partie fixe en position fermée.

L'invention se rapporte également à un procédé de fixation d'un équipement embarqué dans un aéronef, utilisant un support tel que défini précédemment, comprenant les étapes consistant à :
- disposer l'équipement sur la partie fixe du support, la partie mobile se trouvant en position ouverte,
- déplacer la partie mobile par rapport à la partie fixe de la position ouverte à la position fermée pour mettre en prise les moyens de raccordement électriques de la partie mobile et de l'équipement.

D'autres caractéristiques et avantages ressortiront encore de la description qui suit, laquelle est purement illustrative et non limitative et doit être lue en regard des figures annexées parmi lesquelles :
- la figure 1 représente de manière schématique et en perspective, un support de fixation, conforme à un premier mode de réalisation de l'invention,
- les figures 2 à 5 illustrent de manière schématique des étapes d'un procédé de fixation d'un équipement embarqué sur le support de la figure 1,
- la figure 6 représente de manière schématique et en perspective, un support de fixation, conforme à un deuxième mode de réalisation de l'invention,
- les figures 7 et 8 illustrent de manière schématique des étapes d'un procédé de fixation d'un équipement embarqué sur le support de la figure 6,
- les figures 9 et 10 représentent de manière schématique et en perspective, un support de fixation, conforme à un troisième mode de réalisation de l'invention,
- les figures 11 à 13 illustrent de manière schématique des étapes d'un procédé de fixation d'un équipement embarqué sur le support des figures 9 et 10.

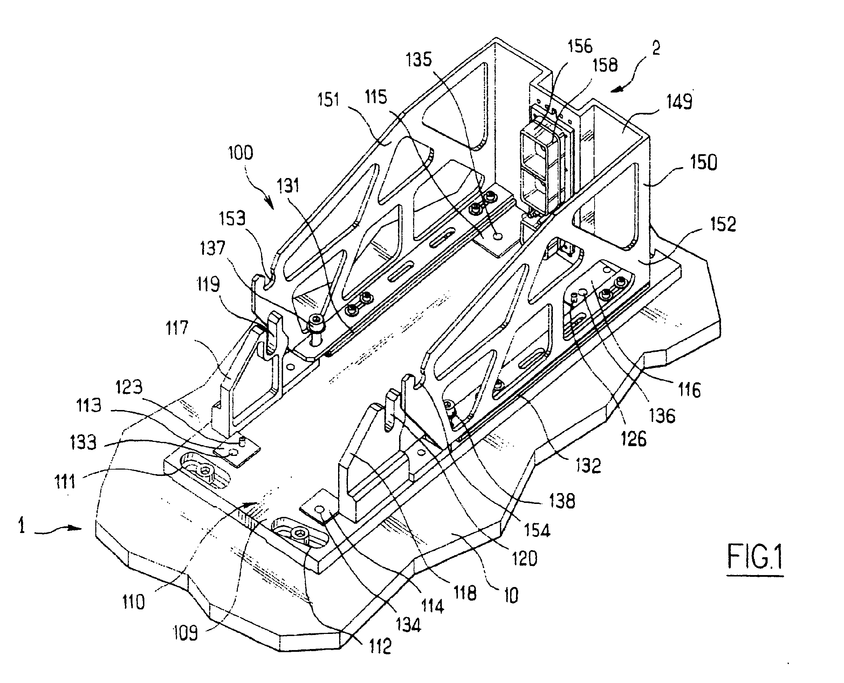

La figure 1 représente un support de fixation 100, conforme à un premier mode de réalisation de l'invention. Ce mode de réalisation est en particulier adapté à l'installation d'un équipement dans une baie ou rack.

Le support 100 comprend une zone avant 1 accessible par un opérateur, et une zone arrière 2 de raccordement électrique.

Le support 100 comprend une partie fixe 110 et une partie mobile 150. Sur la figure 1, la partie mobile 150 se trouve en position ouverte.

La partie fixe 110 comprend un socle 109 de forme générale rectangulaire plane. La partie fixe 110 est destinée à être fixée de manière rigide à une structure 10 d'avion. A cet effet, le socle 109 comprend des ouvertures oblongues 111, 112 destinées à recevoir des vis. Grâce aux ouvertures oblongues 111, 112, la partie fixe 110 peut être positionnée avec précision par rapport au référentiel de l'avion.

La partie fixe 110 comprend quatre plots de positionnement 113, 114, 115 et 116 disposés aux quatre coins du socle 109. Chaque plot de positionnement 113, 114, 115 et 116 est muni d'un orifice taraudé 133, 134, 135 et 136 destiné à recevoir une vis de fixation. Deux des plots 113 et 116 sont munis de pions de positionnement 123 et 126.

En outre, la partie fixe 110 comprend deux guides ou rails 131 et 132 rectilignes parallèles s'étendant chacun le long de l'un des grands côtés du socle 109.

La partie fixe 110 comprend deux pattes 117 et 118 disposées dans la zone avant du support, le long des grand côtés du socle 109. Les pattes 117 et 118 s'étendent dans une direction générale perpendiculaire au socle 109, et présentent au niveau de leur extrémité libre des encoches 119 et 120 allongées rectilignes.

La partie mobile 150 comprend une paroi s'étendant perpendiculairement au socle 109, et présentant une forme de U. La paroi en forme de U comprend une portion centrale 149 s'étendant le long du petit côté arrière du socle 109, et deux portions latérales 151 et 152 s'étendant chacune le long d'un grand côté du socle 109.

La portion centrale 149 comprend des moyens de raccordement électrique sous la forme d'un connecteur mâle 156 rectangulaire. Le connecteur 156 est monté flottant sur la portion centrale 149 et comprend des moyens de guidage 158 destinés à guider un connecteur femelle complémentaire.

Les portions latérales 151 et 152 s'étendent le long des guides 131 et 132 et sont montées coulissantes sur ceux-ci. Chacune des portions latérales 151 et 152 comprend vers l'avant des encoches respectivement 153 et 154.

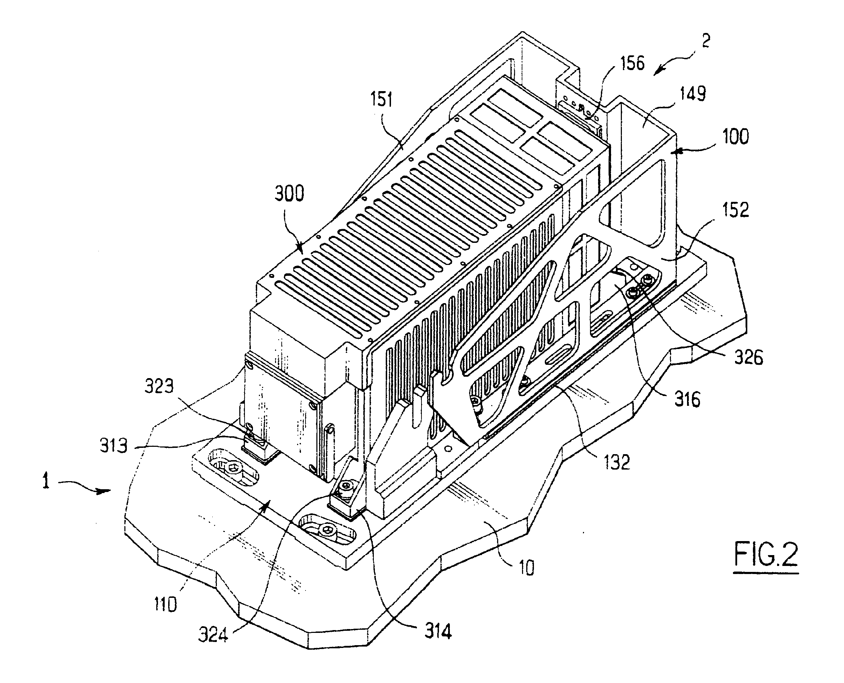

Les figures 2 à 5 illustrent des étapes d'un procédé de fixation d'un équipement embarqué 300 sur le support 100 de la figure 1.

Selon une première étape représentée sur la figure 2, un opérateur fixe l'équipement 300 sur la partie fixe 110 du support 100.

A cet effet, l'opérateur introduit l'équipement 300 sur le socle 109 par la partie avant 1 du support 100. L'opérateur dispose l'équipement 300 entre les portions latérales 151 et 152 de la partie mobile 150.

L'équipement 300 présente une forme générale parallélépipédique. Il comprend quatre pattes 313, 314, 315 (non visible sur la figure 2) et 316 présentant des faces aptes à venir en appui sur les plots 113, 114, 115 (non visible sur la figure 2) et 116. Par ailleurs, les pattes 313 et 316 sont percées d'orifices de positionnement (non visibles sur la figure 2) aptes à recevoir les pions de positionnement 123 et 126. Les pions de positionnement et les orifices permettent de fixer de manière précise l'équipement 300 par rapport au référentiel de l'avion, avec une grande répétabilité.

L'équipement 300 est ensuite verrouillé en position sur les plots 113, 114, 115 et 116 au moyen de vis 323, 324, 325, 326.

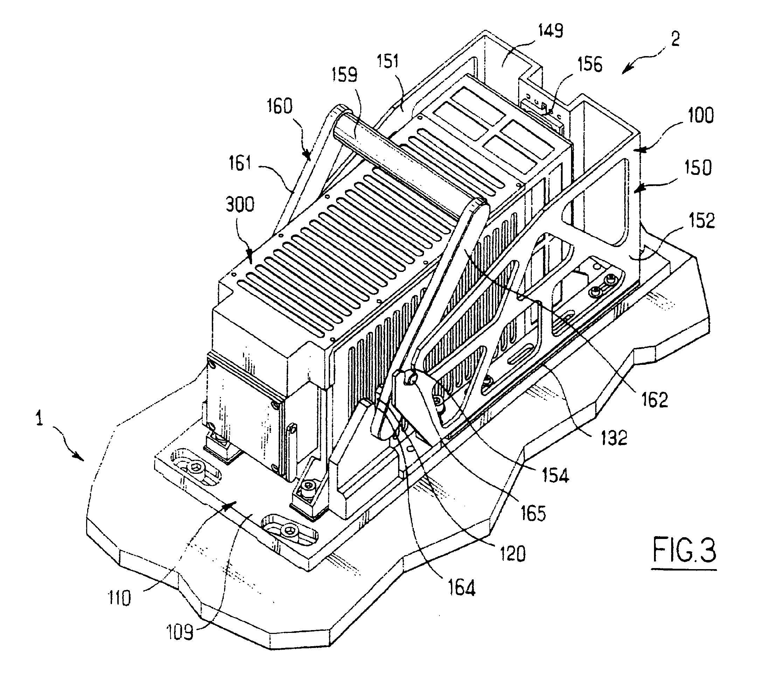

Selon une deuxième étape représentée sur la figure 3, l'opérateur dispose une poignée amovible 160 entre la partie fixe 110 et la partie mobile 150 du support 100.

La poignée 160 présente une forme générale de U. Elle comprend une portion centrale 159 de préhension et deux portions latérales 161, 162 formant des bras de levier.

Chaque portion latérale 161 et 162 est muni d'un premier axe 164 et d'un deuxième axe 165. Le premier axe 164 s'étend vers l'intérieur du U formé par la poignée 160 et le deuxième axe 165 s'étend vers l'extérieur du U.

L'opérateur dispose la poignée de manière à introduire les premiers axes 164 de la poignée 160 dans les encoches 119 et 120 de la partie fixe 110, et les deuxième axes 165 dans les encoches 153 et 154 de la partie mobile 150. La poignée 160 est ainsi montée rotative d'une part sur la partie fixe 110 par l'intermédiaire des premiers axes 164 et d'autre part sur la partie mobile 150 par l'intermédiaire des deuxièmes axes 165.

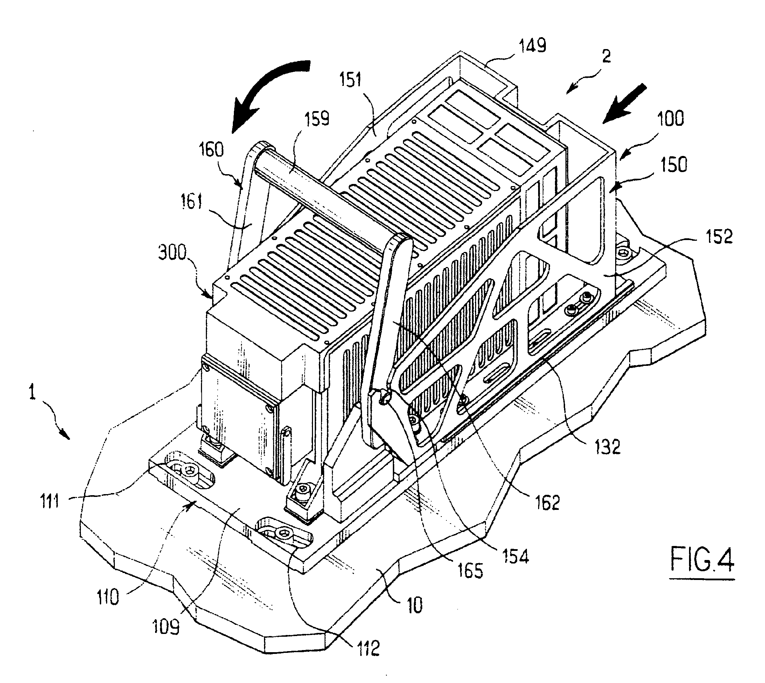

Selon une troisième étape représentée sur la figure 4, l'opérateur entraîne la partie mobile 150 en déplacement de la position ouverte vers une position fermée. A cet effet, l'opérateur saisit la partie de préhension 159 de la poignée 160 et tire la partie de préhension 159 vers l'avant 2 du support. L'opérateur entraîne en rotation la poignée 160 par rapport à la partie mobile 150 par l'intermédiaire des deuxièmes axes 165. Par effet de levier, la partie mobile 150 du support 100 coulisse sur les guides 131 et 132 de la partie fixe 110 du support vers l'avant 1 du support 100. L'opérateur entraîne en rotation la poignée 160 par rapport à la partie fixe 110 par l'intermédiaire des premiers axes 164, de sorte que les premiers axes 164 coulissent dans les encoches rectilignes 119 et 120 de la partie fixe 110.

La partie mobile 150 du support 100 est entraînée en translation par rapport à la partie fixe 110 du support vers l'avant 1 du support 100, de sorte que la portion arrière 149 de la partie mobile 150 se rapproche de l'arrière de l'équipement 300 et les moyens de raccordement électrique du support 100 viennent en prise avec des moyens de raccordement électrique de l'équipement 300. Plus précisément, le connecteur mâle 156 de la partie mobile 150 est mis en prise avec un connecteur rectangulaire femelle complémentaire (non représenté) situé à l'arrière de l'équipement 300.

Les guides 131 et 132 assurent la translation de la partie mobile 150 du support 100 par rapport à la partie fixe 110 et par rapport à l'équipement 300. Par conséquent, cela permet un guidage des moyens de raccordement électrique l'un par rapport à l'autre lors de leur mise en prise mutuelle.

La poignée 160 permet de multiplier l'effort exercé par l'opérateur pour mettre en prise les moyens de raccordement électrique.

Il s'ensuit que le raccordement électrique de l'équipement est réalisé de manière simple et rapide.

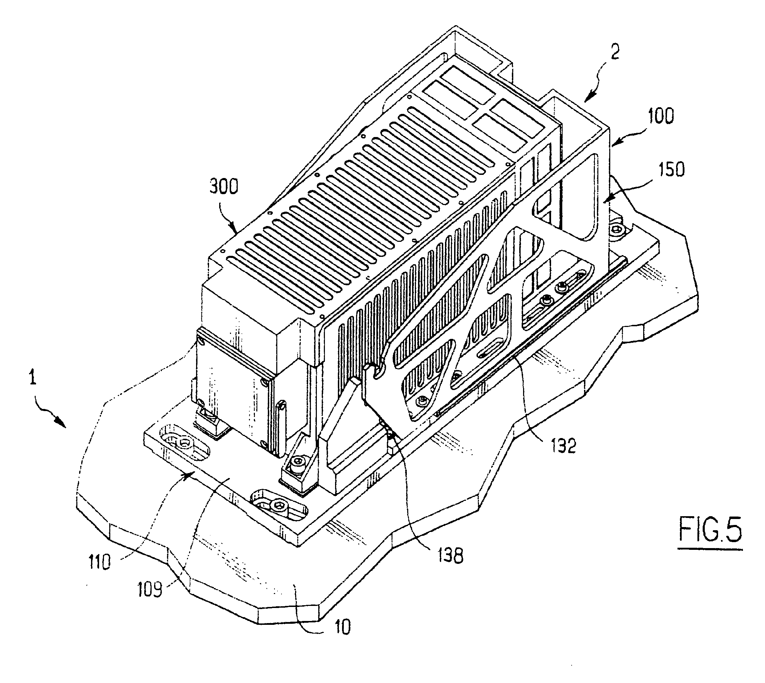

Selon une quatrième étape représentée sur la figure 5, la poignée amovible 160 a été retirée. L'opérateur verrouille la partie mobile 150 sur la partie fixe 110 en position fermée. A cet effet, le support 100 comprend des moyens de verrouillage incluant des vis imperdables 137 et 138 disposées sur les portions latérales 151 et 152 de la partie mobile 150.

Le verrouillage de la partie mobile 150 sur la partie fixe 110 du support 100 permet de maintenir en prise les moyens de raccordement électrique.

L'opération de verrouillage est réalisée dans la zone avant 1 du support, accessible par l'opérateur.

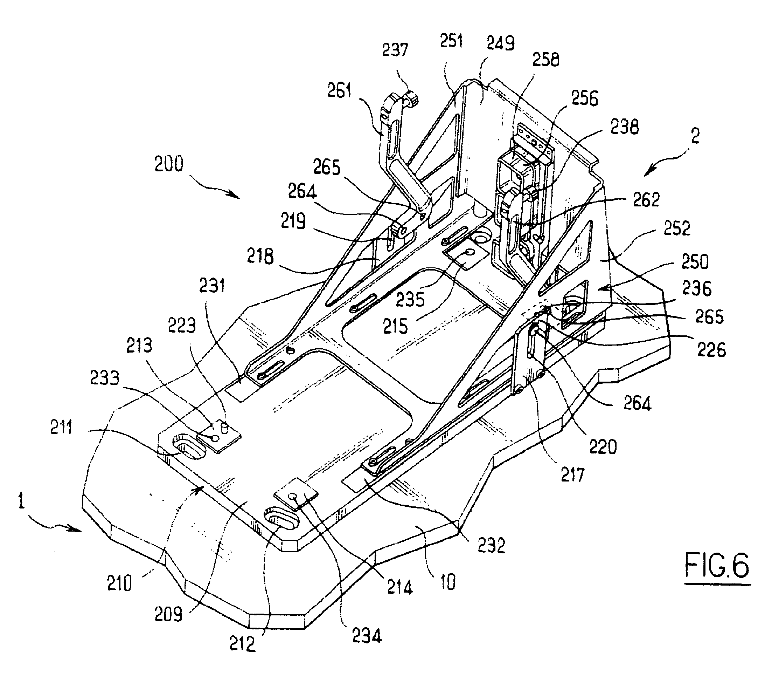

La figure 6 représente un support de fixation 200, conforme à un deuxième mode de réalisation de l'invention.

Le support 200 comprend une zone avant 1 accessible par un opérateur, et une zone arrière 2 de raccordement électrique.

Le support 200 comprend une partie fixe 210 et une partie mobile 250. Sur la figure 6, la partie mobile 250 se trouve en position ouverte.

La partie fixe 210 comprend un socle 209 de forme générale rectangulaire plane. La partie fixe 210 est destinée à être fixée de manière rigide à une structure 10 d'avion. A cet effet, le socle 209 comprend des ouvertures oblongues 211, 212 destinées à recevoir des vis. Grâce aux ouvertures oblongues 211, 212, la partie fixe 210 peut être positionnée avec précision par rapport au référentiel de l'avion.

La partie fixe 210 comprend quatre plots de positionnement 213, 214, 215 et 216 disposés aux quatre coins du socle 209. Chaque plot de positionnement 213, 214, 215 et 216 est muni d'un orifice taraudé 233, 234, 235 et 236 destiné à recevoir une vis de fixation. Deux des plots 213 et 216 sont munis de pions de positionnement 223 et 226.

En outre, la partie fixe 210 comprend deux guides ou rails 231 et 232 rectilignes parallèles s'étendant chacun le long de l'un des grands côtés du socle 209.

La partie fixe 210 comprend deux pattes latérales 217 et 218 disposées dans la zone arrière 2 du support, le long des grands côtés du socle 209. Les deux pattes 217 et 218 sont fixées sur le socle 209 au moyen de vis. Les pattes 217 et 218 s'étendent dans une direction générale perpendiculaire au socle 209. Les pattes 217 et 218 présentent des ouvertures 219 et 220 allongées rectilignes s'étendant dans une direction générale perpendiculaire au socle 209.

La partie mobile 250 comprend une paroi s'étendant perpendiculairement au socle 209, et présentant une forme de U. La paroi en forme de U comprend une portion centrale 249 s'étendant le long du petit côté arrière du socle 209, et deux portions latérales 251 et 252 s'étendant le long chacune le long d'un grand côté du socle 209.

La portion centrale 249 comprend des moyens de raccordement électrique sous la forme d'un connecteur mâle 256 rectangulaire. Le connecteur 256 est monté flottant sur la portion centrale 249 et comprend des moyens de guidage 258 destinés à guider un connecteur femelle complémentaire.

Les portions latérales 251 et 252 s'étendent le long des guides 231 et 232 et sont montées coulissantes sur ceux-ci.

Par ailleurs, la partie mobile 250 comprend deux bras 261 et 262 montés chacun sur l'une des portions latérales 251 et 252. Chaque bras 261 et 262 est muni d'un premier axe 264 et d'un deuxième axe 265.

Les bras 261 et 262 sont montés en rotation sur la partie mobile 250 du support 200 par l'intermédiaire des deuxième axes 264.

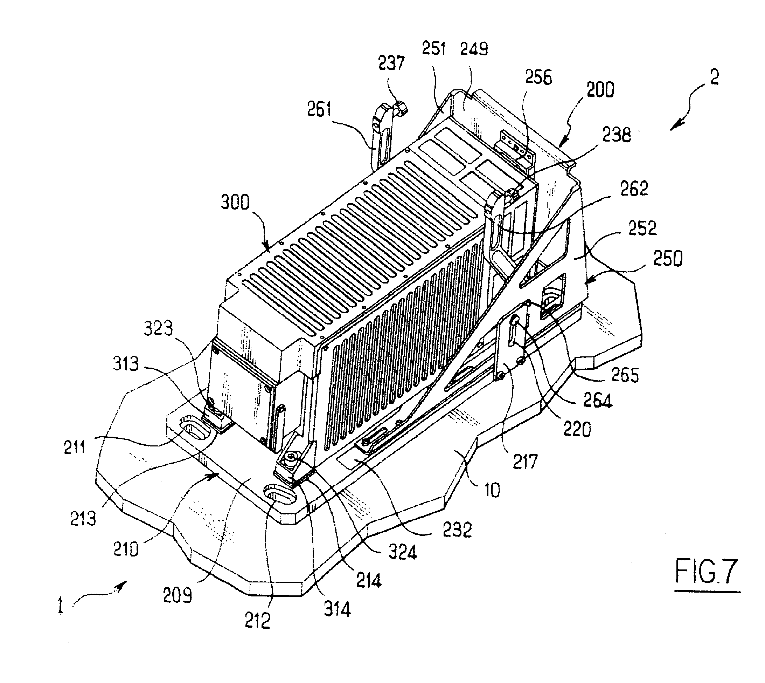

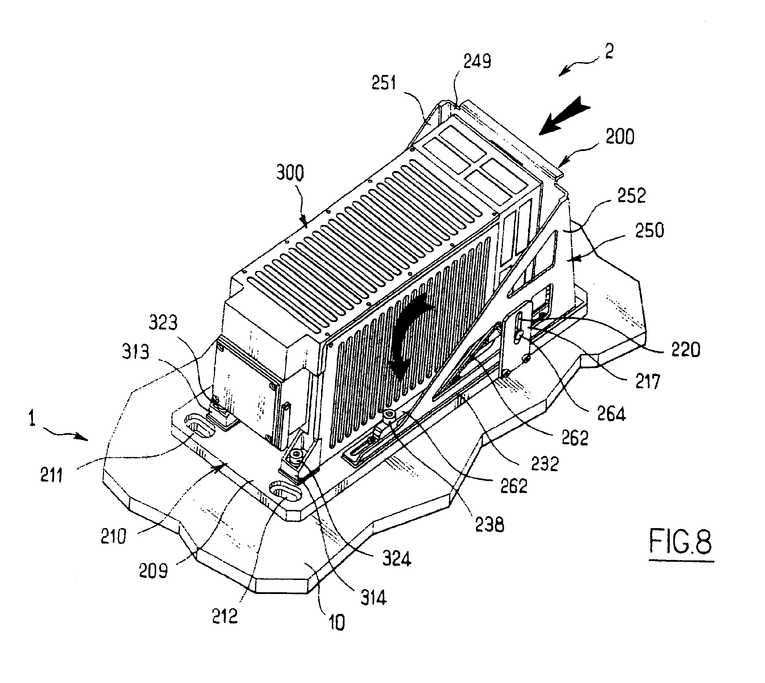

Les figures 7 et 8 illustrent des étapes d'un procédé de fixation d'un équipement embarqué 300 sur le support 200 de la figure 6.

Selon une première étape représentée sur la figure 7, un opérateur fixe l'équipement 300 sur la partie fixe 210 du support 200.

A cet effet, l'opérateur introduit l'équipement 300 sur le socle 209 par la partie avant 1 du support 200. L'opérateur dispose l'équipement 300 entre les portions latérales 251 et 252 de la partie mobile 250.

L'équipement 300 est identique à l'équipement des figures 2 à 5.

L'équipement 300 est ensuite verrouillé en position sur les plots 113, 114, 115 et 116 au moyen de vis 323, 324, 325, 326.

Selon une deuxième étape représentée sur la figure 8, l'opérateur déplace la partie mobile 250 de la position ouverte vers une position fermée. A cet effet, l'opérateur saisit les bras 261 et 262 et les fait pivoter vers l'avant 2 du support.

L'opérateur entraîne en rotation les bras 261 et 262 par rapport à la partie mobile 250 par l'intermédiaire des deuxièmes axes 265. Par effet de levier, la partie mobile 250 du support 200 coulisse sur les guides 231 et 232 de la partie fixe 210 du support vers l'avant 1 du support 200.

L'opérateur entraîne en rotation les bras 261 et 262 par rapport à l'équipement 300 par l'intermédiaire des premiers axes 264, de sorte que les premiers axes 264 coulissent dans les ouvertures rectilignes 219 et 220 de la partie fixe 210.

La partie mobile 250 du support 200 est entraînée en translation par rapport à la partie fixe 210 du support vers l'avant 1 du support 200, de sorte que la portion arrière 249 de la partie mobile 250 se rapproche de l'arrière de l'équipement 300 et les moyens de raccordement électrique 256 du support 200 viennent en prise avec des moyens de raccordement électrique de l'équipement 300. Plus précisément, le connecteur mâle 256 de la partie mobile 250 est mis en prise avec un connecteur rectangulaire femelle complémentaire (non représenté) situé à l'arrière de l'équipement 300.

Les guides 231 et 232 assurent la translation de la partie mobile 250 du support 200 par rapport à la partie fixe 210 et par rapport à l'équipement 300. Par conséquent, cela permet un guidage des moyens de raccordement électrique l'un par rapport à l'autre lors de leur mise en prise mutuelle.

Puis, l'opérateur verrouille la partie mobile 250 sur la partie fixe 210 en position fermée. A cet effet, les bras 261 et 262 comprennent des moyens de verrouillage incluant des vis imperdables 237 et 238 disposées au niveau des extrémités libres des bras.

Le verrouillage des bras 261 et 262 sur la partie fixe 210 du support 200 permet de maintenir en prise les moyens de raccordement électrique.

L'opération de verrouillage est réalisée dans la zone avant 1 du support, accessible par l'opérateur.

Dans les deux modes de réalisation qui viennent d'être décrits, les différentes étapes de fixation de l'équipement sur le support sont réalisées par un opérateur ayant accès à la zone avant 1 du support tandis que la connexion électrique de l'équipement est réalisée dans la zone arrière 2 du support.

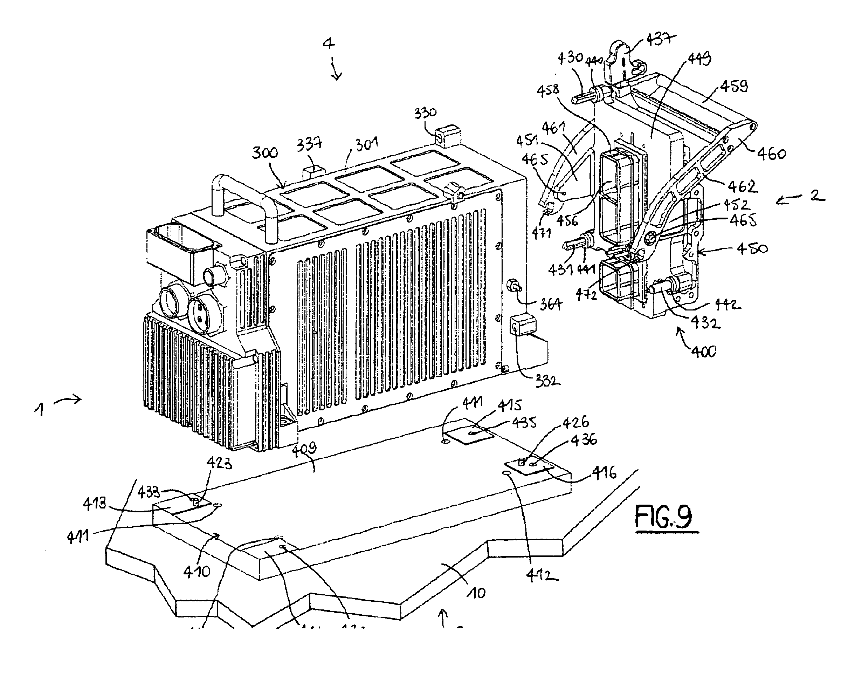

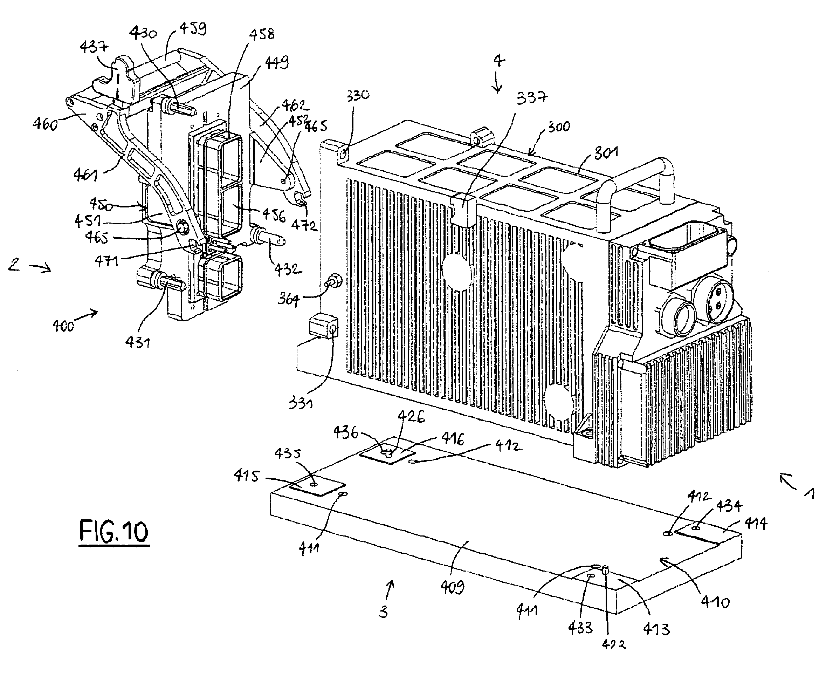

Les figures 9 et 10 représentent un support de fixation 400, conforme à un troisième mode de réalisation de l'invention. Ce mode de réalisation est plus particulièrement adapté à l'installation d'un équipement dans un compartiment ménagé sous le plancher de la cabine de l'avion.

Le support 400 comprend une zone avant 1, une zone arrière 2 de raccordement électrique, une zone basse 3 et une zone haute 4 accessible par un opérateur.

Dans ce troisième mode de réalisation, le support 400 comprend une partie fixe 410 et une partie mobile 450 dissociables. La partie fixe 410 est destinée à être disposée dans la zone basse 3 du support et la partie mobile 450 est destinée à être disposée dans la zone arrière 2 du support. Sur les figures 9 et 10, la partie mobile 450 se trouve en position ouverte.

La partie fixe 410 comprend un socle 409 de forme générale rectangulaire plane. La partie fixe 410 est destinée à être fixée de manière rigide à une structure 10 d'avion. A cet effet, le socle 409 comprend des ouvertures 411, 412 destinées à recevoir des vis.

La partie fixe 410 comprend quatre plots de positionnement 413, 414, 415 et 416 disposés aux quatre coins du socle 409. Chaque plot de positionnement 413, 414, 415 et 416 est muni d'un orifice taraudé 433, 434, 435 et 436 destiné à recevoir une vis de fixation. En outre, deux des plots 413 et 416 sont munis de pions de positionnement 423 et 426.

La partie mobile 450 comprend une paroi s'étendant perpendiculairement au socle 409. La paroi comprend une portion centrale 449 et deux portions latérales 451 et 452 s'étendant à partir de la portion centrale 449, en direction de la zone avant 1 du support, perpendiculairement à la portion centrale 449.

La portion centrale 449 comprend des moyens de raccordement électrique sous la forme d'un connecteur mâle 456 rectangulaire. Le connecteur 456 est monté fixe sur la portion centrale 449 et comprend des moyens de guidage 458 destinés à guider un connecteur femelle complémentaire.

Chacune des portions latérales 451 et 452 comprend au niveau de son extrémité libre un pivot 465.

La partie mobile 450 comprend en outre des doigts de guidage 430, 431 et 432 fixées sur la portion centrale 449 de la paroi et s'étendant dans une direction perpendiculaire à cette dernière, en direction de la zone avant 2 du support.

La partie mobile 450 comprend des rondelles 440, 441 et 442 en matériau élastique, chaque rondelle 440, 441 et 442 étant disposée autour d'un doigt de guidage 430, 431 et 432.

Dans ce troisième mode de réalisation, l'équipement 300 est différent de l'équipement 300 des modes de réalisation précédents. En effet, l'équipement 300 comprend des canons fixés sur le bâti 301 de l'équipement 300. Les canons présentant des orifices de guidage 330, 331 et 332. Les orifices de guidage 330, 331 et 332 sont rectilignes et s'étendent parallèlement aux grands côtés du socle 409 lorsque l'équipement est disposé sur le socle 409.

En outre, l'équipement 300 comprend des plots 364 fixés sur le bâti 301 de l'équipement 300 et présentant une forme générale cylindrique.

Les doigts de guidage 430, 431 et 432 sont agencés pour pouvoir être introduits dans les orifices de guidage 330, 331 et 332 de l'équipement 300. Les doigts de guidage 430, 431 et 432 sont aptes à être introduits simultanément dans les orifices de guidage 330, 331 et 332 de sorte que la partie mobile 450 peut être montée coulissante par rapport à l'équipement 300.

Le support 400 comprend également une poignée 460. La poignée 460 présente une forme générale de U. Elle comprend une portion centrale 459 de préhension et deux portions latérales 461, 462 formant des bras de levier.

Les portions latérales 461 et 462 sont montées rotative par rapport aux portions latérales 451 et 452 sur les pivots 465. Ainsi, la poignée 460 est montée rotative sur la paroi de la partie mobile 450.

Chacune des portions latérales 461 et 462 présente au niveau de son extrémité libre une encoche 471 et 472. Chaque encoche 471 et 472 comprend une surface de came destinée à venir en contact avec l'un des plots de guidage 364. Les plots de guidage 364 sont aptes à être insérés dans les encoches 471 et 472 de la poignée 460 de sorte que les plots 364 forment des pivots permettant de monter la poignée 460 rotative par rapport au bâti 301 de l'équipement 300

La poignée 460 comprend des moyens de verrouillage, incluant un loquet 437 fixé sur l'un des bras 461 de la poignée 460 et un ressort (non représenté), aptes à venir en prise avec des moyens de verrouillage complémentaires prévus sur l'équipement 300, comprenant un organe de réception 337 du loquet.

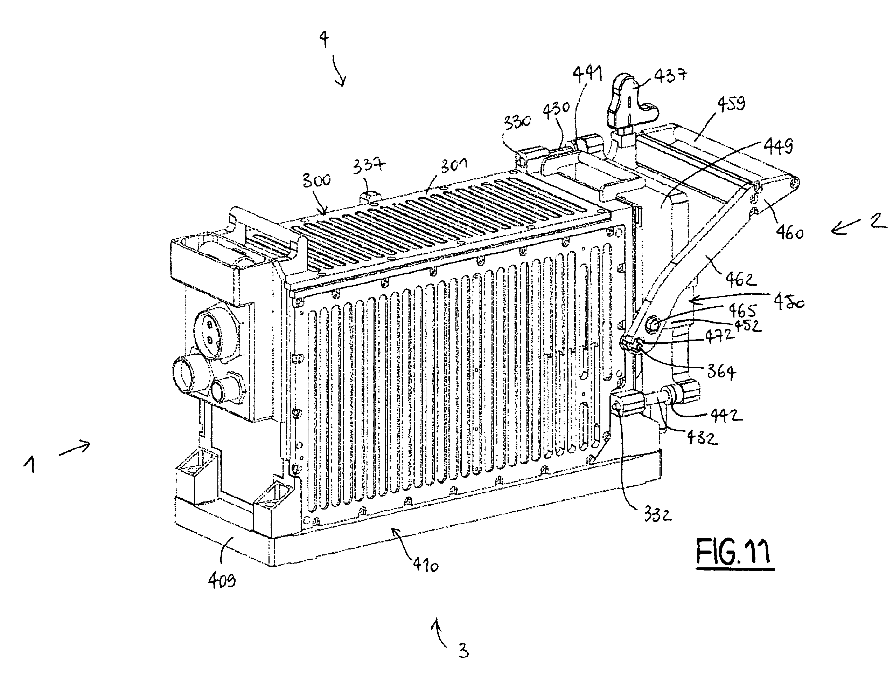

Les figures 11 à 13 illustrent des étapes d'un procédé de fixation d'un équipement embarqué 300 sur le support 400 de la figure 9.

Selon une première étape représentée sur la figure 10, un opérateur fixe l'équipement 300 sur la partie fixe 410 du support 400.

A cet effet, l'opérateur introduit l'équipement 300 sur le socle 409 par la zone haute 4 du support 400.

Puis l'opérateur amène la partie mobile 450 en regard de l'équipement 300 au niveau de la partie arrière 2 du support 400.

Dans cette position, les extrémités libres des doigts de guidage 430, 431 et 432 se trouvent engagées dans les orifices de guidage 330, 331 et 332 de l'équipement 300. En outre, les plots 364 se trouvent engagés dans les encoches 471 et 472 de la poignée 460.

Les doigts de guidage 430, 431 et 432 et les orifices de guidages 330, 331 et 332 permettent ainsi un pré positionnement de la partie mobile 450 par rapport à l'équipement 300 (et à la partie fixe 410).

La poignée 460 est montée rotative d'une part sur l'équipement 300 par l'intermédiaire des plots 364 et des encoches 471, 472 et d'autre part sur la partie mobile 450 par l'intermédiaire des pivots 465.

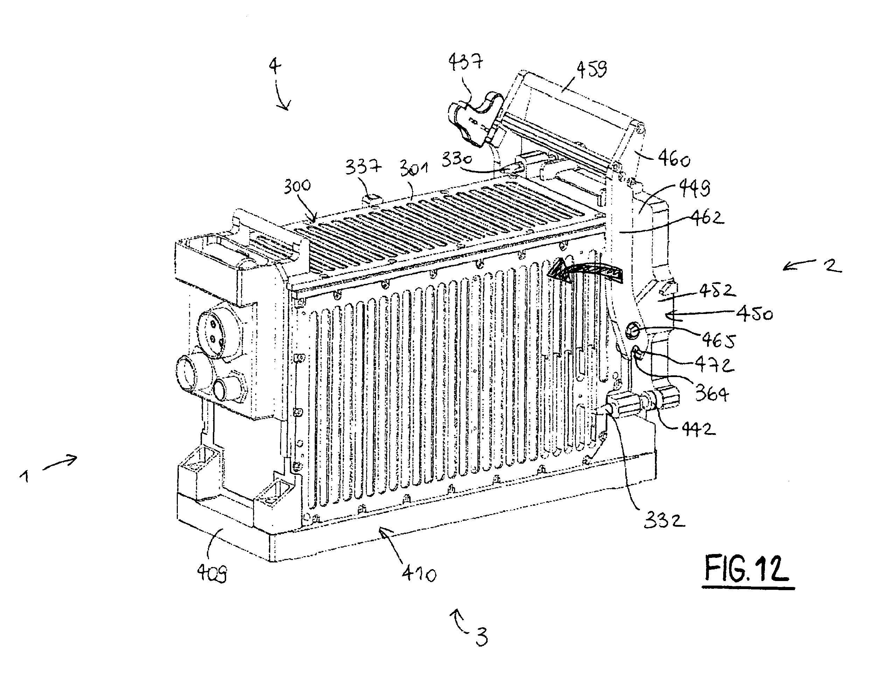

Selon une deuxième étape représentée sur la figure 12, l'opérateur entraîne la partie mobile 450 en déplacement de la position ouverte vers une position fermée. A cet effet, l'opérateur saisit la partie de préhension 459 de la poignée 460 accessible par le haut 4 du support et tire la partie de préhension 459 vers l'avant 1 du support.

Au cours de cette deuxième étape, l'opérateur entraîne en rotation la poignée 460 par rapport à la partie mobile 450 par l'intermédiaire des plot 465. Par effet de levier, la partie mobile 450 du support 400 coulisse dans les orifices de guidage 330, 331 et 332 de l'équipement 300 vers l'avant 1 du support 400.

En outre, au cours de cette deuxième étape, l'opérateur entraîne également en rotation la poignée 460 par rapport à l'équipement 300 (donc par rapport à la partie fixe 410) par l'intermédiaire des plots 364, de sorte que les encoches 471 et 472 viennent en prise avec les plots 364. Au cours de la rotation de la poignée 460, les plots 364 glissent sur les surfaces de came des encoches 471 et 472 de la poignée 460.

Cela a pour effet que la partie mobile 450 du support 400 est entraînée en translation par rapport à l'équipement 300 (et par rapport à la partie fixe 410 du support) vers l'avant 1 du support 400, de sorte que la portion arrière 449 de la partie mobile 450 se rapproche de la partie arrière de l'équipement 300 et les moyens de raccordement électrique du support 400 viennent en prise avec des moyens de raccordement électrique de l'équipement 300. Plus précisément, le connecteur mâle 456 de la partie mobile 450 est mis en prise avec un connecteur rectangulaire femelle complémentaire (non représenté) situé à l'arrière de l'équipement 300 et monté flottant par rapport à l'équipement 300.

Les doigts de guidage 430, 431 et 432 et les orifices de guidage 330, 331 et 332 assurent un guidage en translation de la partie mobile 450 du support 400 par rapport à l'équipement 300 et à la partie fixe 410. Par conséquent, cela permet un enfichage des moyens de raccordement électrique l'un par rapport à l'autre lors de leur mise en prise mutuelle.

La poignée 460 permet de multiplier l'effort exercé par l'opérateur pour mettre en prise les moyens de raccordement électrique.

Il s'ensuit que le raccordement électrique de l'équipement est réalisé de manière simple et rapide.

En outre, la partie mobile 450 vient presser les rondelles élastiques 440, 441 et 442 contre les canons de l'équipement 300. Les rondelles élastiques 440, 441 et 442 forment ainsi des moyens de butée élastique qui permettent une immobilisation de la partie mobile 450 par rapport à l'équipement 300.

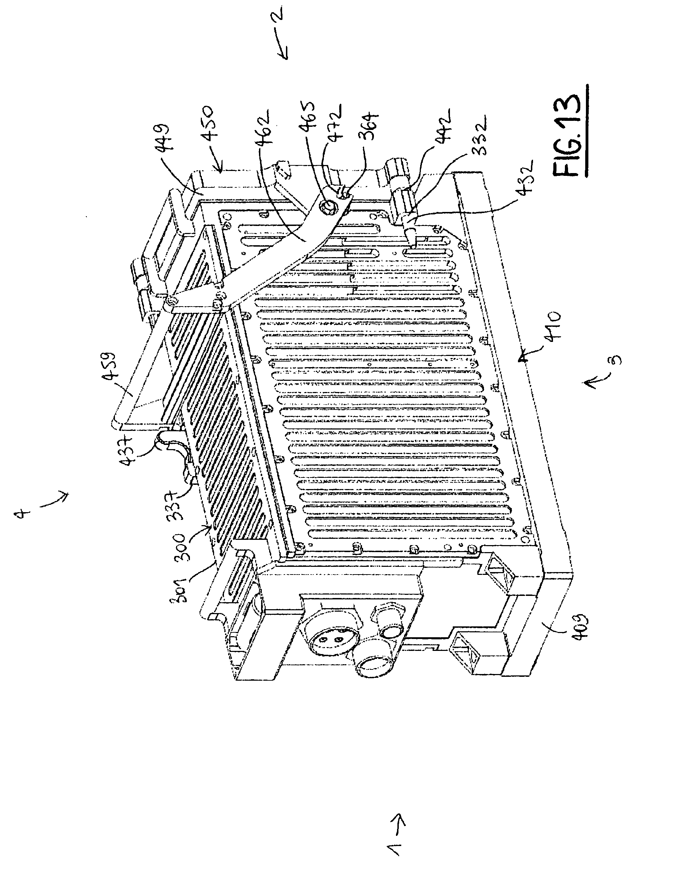

Selon une troisième étape représentée sur la figure 13, l'opérateur verrouille la partie mobile 450 sur la partie fixe 410 en position fermée. Lors de la rotation de la poignée 460, le loquet 437 vient s'insérer dans l'organe de réception 337.

Le verrouillage de la partie mobile 450 sur l'équipement 300 permet de maintenir en prise les moyens de raccordement électrique.

L'opération de verrouillage est réalisée dans la zone haute 4 du support, accessible par l'opérateur.

Dans le troisième mode de réalisation qui vient d'être décrit, les différentes étapes de fixation de l'équipement sur le support sont réalisées par un opérateur ayant accès à la zone haute 4 du support tandis que la connexion électrique de l'équipement est réalisée dans la zone arrière 2 du support.

Bien entendu l'invention n'est aucunement limitée à l'utilisation d'une poignée ou de bras, mais s'étend à tout dispositif adapté pour permettre un mouvement relatif de translation entre la position mobile et la partie fixe (par exemple système vis-écrou monté horizontalement, système verrou-came, système d'engrenages, système à roue et vis sans fin, etc.).

Le support est facile à manipuler. Il permet d'installer facilement un équipement alors que la connexion électrique est réalisée par l'arrière de l'équipement dans une zone peu accessible pour l'opérateur.

Les parties fixes et mobiles du support sont agencées pour s'étendre le long des faces de l'équipement de sorte que le support occupe un espace réduit autour de l'équipement.

Le support est ainsi particulièrement peu encombrant.

## Revendications

1. Support de fixation (100, 200, 400) pour un équipement embarqué (300) dans un aéronef, comprenant une partie fixe (110, 210, 410), une partie mobile (150, 250, 450), et des moyens de liaison (131, 132, 231, 232, 430, 431, 432) entre la partie fixe (110, 210, 410) et la partie mobile (150, 250, 450), la partie mobile (150, 250, 450) comprenant des moyens de raccordement électriques (156, 256, 456) destinés à être mis en prise avec des moyens de raccordement électriques complémentaires de l'équipement (300), les moyens de liaison (131, 132, 231, 232, 430, 431, 432) étant agencés de sorte que la partie mobile (150, 250, 450) est déplaçable par rapport à la partie fixe (110, 210, 410) entre une position ouverte permettant de fixer l'équipement (300) sur la partie fixe (110, 210, 410), et une position fermée, le déplacement de la partie mobile (150, 250, 450) de la position ouverte à la position fermée provoquant la mise en prise des moyens de raccordement électriques de la partie mobile et de l'équipement.

2. Support selon la revendication 1, dans lequel les moyens de liaison (131, 132, 231, 232, 430, 431, 432) entre la partie fixe (110, 210, 410) et la partie mobile (150, 250, 450) comprennent des moyens de guidage de la partie fixe (110, 210, 410) par rapport à la partie mobile (150, 250, 450).

3. Support selon la revendication 2, dans lequel les moyens de guidage sont rectilignes.

4. Support selon l'une des revendications 2 ou 3, dans lequel les moyens de guidage comprennent au moins un rail.

5. Support selon l'une des revendications 2 ou 3, dans lequel les moyens de guidage comprennent au moins un doigt de guidage (430, 431, 432) apte à coopérer avec un orifice de guidage (330, 331, 332).

6. Support selon l'une des revendications qui précèdent, dans lequel les moyens de liaison (131, 132, 231, 232, 430, 431, 432) entre la partie fixe (110, 210, 410) et la partie mobile (150, 250, 450) sont adaptés pour permettre un coulissement de la partie mobile (150, 250, 450) sur la partie fixe (150, 250, 450).

7. Support selon l'une des revendications qui précèdent, dans lequel les moyens de raccordement électrique (156, 256, 456) de la partie mobile (150, 250, 450) comprennent des moyens (158, 258, 458) pour guider les moyens de raccordement de l'équipement (300) lors de leur mise en prise.

8. Support selon l'une des revendications qui précèdent, dans lequel la partie fixe (110, 210) comprend des plots (113, 114, 115, 116, 213, 214, 215, 216, 413, 414, 415, 416) de positionnement de l'équipement (300) sur la partie fixe (110, 210, 410), sur lesquels l'équipement (300) peut venir en appui.

9. Support selon la revendication 8, dans lequel l'équipement (300) est verrouillé en position sur les plots (113, 114, 115, 116, 213, 214, 215, 216, 413, 414, 415, 416) au moyen de vis (323, 324, 325, 326).

10. Support selon l'une des revendications qui précèdent, dans lequel la partie fixe (110, 210, 410) comprend des pions (123, 126, 223, 226, 423, 426) destinés à être insérés dans des orifices de l'équipement (300) pour positionner l'équipement (300) sur le support (100, 200, 400).

11. Support selon l'une des revendications qui précèdent, comprenant au moins un bras (161, 162, 261, 262, 461, 462) apte à être actionné pour entraîner, par effet de levier, le déplacement de la partie mobile (150, 250, 450) par rapport à la partie fixe (110, 210, 410).

12. Support selon la revendication 11, comprenant un premier axe (164, 264) et un deuxième axe (165, 265), le bras (161, 162, 261, 262) étant apte à être monté rotatif par rapport à la partie fixe (110, 210) ou à l'équipement (300) par l'intermédiaire du premier axe (164, 264) et étant apte à être monté rotatif par rapport à la partie mobile (150, 250) par l'intermédiaire du deuxième axe (165, 265).

13. Support selon la revendication 12, dans lequel le premier axe (164, 264) est apte à coulisser par rapport à la partie fixe (110, 210) ou par rapport à l'équipement (300).

14. Support selon la revendication 13, dans lequel la partie fixe (110) comprend une encoche ou une ouverture (119, 120, 219, 220) dans laquelle le premier axe (164) peut coulisser.

15. Support selon la revendication 11, comprenant une encoche (469, 470) apte à recevoir un plot (364) de l'équipement (300), et un pivot (465), le bras (461, 462) étant apte à être monté rotatif par rapport à la partie fixe (410) ou à l'équipement (300) par l'intermédiaire du plot (364) reçu dans l'encoche (469, 470) et étant apte à être monté rotatif par rapport à la partie mobile (450) par l'intermédiaire du pivot (465).

16. Support selon la revendication 15, dans lequel l'encoche (469, 470) présente une surface de came adaptée pour que le plot glisse sur la surface de came lorsque le bras (461, 462) est entraîné en rotation.

17. Support selon l'une des revendications 11 à 16, dans lequel le bras (261, 262, 461, 462) est monté de manière permanente sur l'une des parties fixe (210, 410) ou mobile (250, 450).

18. Support selon l'une des revendications 11 à 16, dans lequel le bras (161, 162) est monté de manière amovible sur l'une des parties fixe (110) ou mobile (150) de sorte qu'il peut être retiré lorsque la partie mobile (150) est en position fermée.

19. Support selon l'une des revendications qui précèdent, dans lequel la partie fixe (410) et la partie mobile (450) sont dissociables de sorte que la partie mobile (450) peut être séparée de la partie fixe (410) pour permettre de disposer l'équipement sur la partie fixe (410).

20. Support selon l'une des revendications qui précèdent, comprenant des moyens (137, 138, 237, 238, 437) pour verrouiller la partie mobile (150, 250, 450) sur la partie fixe (110, 210, 410) en position fermée.

21. Procédé de fixation d'un équipement embarqué (300) dans un aéronef, utilisant un support (100, 200, 400) selon l'une des revendications 1 à 20, comprenant les étapes consistant à :
- disposer l'équipement (300) sur la partie fixe (110, 210, 410) du support (100, 200, 400), la partie mobile (150, 250, 450) se trouvant en position ouverte,
- déplacer la partie mobile (150, 250, 450) par rapport à la partie fixe (110, 210, 410) de la position ouverte à la position fermée pour mettre en prise les moyens de raccordement électriques (156, 256, 456) de la partie mobile (150, 250, 450) et de l'équipement (300).

22. Partie mobile (450) pour support de fixation (400) selon la revendication 1 pour un équipement embarqué (300) dans un aéronef, la partie mobile (450) comprenant des moyens de raccordement électriques (156, 256, 456) destinés à être mis en prise avec des moyens de raccordement électriques complémentaires de l'équipement (300), la partie mobile (450) comprenant en outre des moyens de liaison (430, 431, 432) aptes à coopérer avec des moyens de liaison complémentaires (330, 331, 332) de l'équipement ou d'une partie fixe (410), les moyens de liaison (430, 431, 432) étant agencés de sorte que la partie mobile (450) est déplaçable par rapport à la partie fixe (410) entre une position ouverte permettant de fixer l'équipement (300) sur la partie fixe (410), et une position fermée, le déplacement de la partie mobile (450) de la position ouverte à la position fermée provoquant la mise en prise des moyens de raccordement électriques de la partie mobile et de l'équipement.

## Claims

1. A support (100, 200, 400) for fastening a piece of equipment on board (300) an aircraft, comprising a stationary part (110, 210, 410) and a mobile part (150, 250, 450), and linking means (131, 132, 231, 232, 430, 431, 432) between the stationary part (110, 210, 410) and the mobile part (150, 250, 450), the mobile part (150, 250, 450) comprising electric connecting means (156, 256, 456) to be engaged with complementary electric connecting means of the piece of equipment (300), with the linking means (131, 132, 231, 232, 430, 431, 432) being arranged so that the mobile part (150, 250, 450) is displaceable with respect to the stationary part (110, 210, 410) between an open position allowing for the piece of equipment (300) to be fastened to the stationary part (110, 210, 410), and a closed position, the displacement of the mobile part (150, 250, 450) from the open position to the closed position causing the engagement of the electric connecting means of the mobile part and the piece of equipment.

2. The support according to claim 1, wherein the linking means (131, 132, 231, 232, 430, 431, 432) between the stationary part (110, 210, 410) and the mobile part (150, 250, 450) comprise means for guiding the stationary part (110, 210, 410) with respect to the mobile part (150, 250, 450).

3. The support according to claim 2, wherein the guiding means are straight.

4. The support according to any of claims 2 or 3, wherein the guiding means comprise at least one rail.

5. The support according to any of claims 2 or 3, wherein the guiding means comprise at least one guide finger (430, 431, 432) adapted to cooperate with a guide orifice (330, 331, 332).

6. The support according to any of the preceding claims, wherein the linking means (131, 132, 231, 232, 430, 431, 432) between the stationary part (110, 210, 410) and the mobile part (150, 250, 450) are adapted to allow for sliding of the mobile part (150, 250, 450) on the stationary part (110, 210, 410).

7. The support according to any of the preceding claims, wherein the electric connecting means (156, 256, 456) of the mobile part (150, 250, 450) comprise means (158, 258, 458) for guiding the connecting means of the piece of equipment (300) as they are engaged.

8. The support according to any of the preceding claims, wherein the stationary part (110, 210) comprises blocks (113, 114, 115, 116, 213, 214, 215, 216, 413, 414, 415, 416) for positioning the piece of equipment (300) on the stationary part (110, 210, 410), on which the piece of equipment (300) may come into abutment.

9. The support according to claim 8, wherein the piece of equipment (300) is locked in position on the blocks (113, 114, 115, 116, 213, 214, 215, 216, 413, 414, 415, 416) by means of screws (323, 324, 325, 326).

10. The support according to any of the preceding claims, wherein the stationary part (110, 210, 410) comprises pins (123, 126, 223, 226, 423, 426) to be inserted into orifices of the piece of equipment (300) for positioning the piece of equipment (300) on the support (100, 200, 400).

11. The support according to any of the preceding claims, comprising at least one arm (161, 162, 261, 262, 461, 462) adapted to be actuated so as to bring about, by lever action, the displacement of the mobile part (150, 250, 450) with respect to the stationary part (110, 210, 410).

12. The support according to claim 11, comprising a first shaft (164, 264) and a second shaft (165, 265), with the arm (161, 162, 261, 262) being adapted to be rotatingly mounted with respect to the stationary part (110, 210) or the piece of equipment (300) via the first shaft (164, 264) and being adapted to be rotatingly mounted with respect to the mobile part (150, 250) via the second shaft (165, 265).

13. The support according to claim 12, wherein the first shaft (164, 264) is adapted to slide with respect to the stationary part (110, 210) or with respect to the piece of equipment (300).

14. The support according to claim 13, wherein the stationary part (110) comprises a notch or opening (119, 120, 219, 220), in which the first shaft (164) may slide.

15. The support according to claim 11, comprising a notch (469, 470) adapted to receive a pin (364) of the piece of equipment (300), and a pivot (465), the arm (461, 462) being adapted to be rotatingly mounted with respect to the stationary part (410) or the piece of equipment (300) via the pin (364) received inside the notch (469, 470) and being adapted to be rotatingly mounted with respect to the mobile part (450) via the pivot (465).

16. The support according to claim 15, wherein the notch (469, 470) has a cam surface adapted for the pin to slide on the cam surface when the arm (461, 462) is rotated.

17. The support according to any of claims 11 to 16, wherein the arm (261, 262, 461, 462) is permanently mounted on one of the stationary (210, 410) or mobile (250, 450) parts.

18. The support according to any of claims 11 to 16, wherein the arm (161, 162) is removably mounted on one of the stationary (110) or mobile (150) parts so that it can be removed when the mobile part (150) is in the closed position.

19. The support according to any of the preceding claims, wherein the stationary part (410) and the mobile part (450) can be dissociated so that the mobile part (450) can be separated from the stationary part (410) in order to allow for the piece of equipment to be arranged on the stationary part (410).

20. The support according to any of the preceding claims, comprising means (137, 138, 237, 238, 437) for locking the mobile part (150, 250, 450) on the stationary part (110, 210, 410) in the closed position.

21. A method for fastening a piece of equipment on board (300) an aircraft, using a support (100, 200, 400) according to any of claims 1 to 20, comprising the following steps:
- fastening the piece of equipment (300) on the stationary part (110, 210, 410) of the support (100, 200, 400), with the mobile part (150, 250, 450) being in the open position,
- displacing the mobile part (150, 250, 450) with respect to the stationary part (110, 210, 410) from the open position to the closed position in order to engage the electric connecting means (156, 256, 456) of the mobile part (150, 250, 450) of the piece of equipment (300).

22. A mobile part (450) for a fastening support (400) according to claim 1 for a piece of equipment on board (300) an aircraft, the mobile part (450) comprising electric connecting means (156, 256, 456) to be engaged with complementary electric connecting means of the piece of equipment (300), the mobile part (450) further comprising linking means (430, 431, 432) adapted for cooperating with complementary linking means (330, 331, 332) of the piece of equipment or a stationary part (410), with the linking means (430, 431, 432) being arranged so that the mobile part (450) is displaceable with respect to the stationary part (410) between an open position allowing for the piece of equipment (300) to be fastened to the stationary part (410), and a closed position, the displacement of the mobile part (450) from the open position to the closed position causing the engagement of the electric connecting means of the mobile part and the piece of equipment.

## Patentansprüche

1. Trägerelement (100, 200, 400) zum Befestigen eines Geräts an Bord (300) eines Luftfahrzeugs, umfassend einen feststehenden Teil (110, 210, 410) und einen beweglichen Teil (150, 250, 450) und Verbindungsmittel (131, 132, 231, 232, 430, 431, 432) zwischen dem feststehenden Teil (110, 210, 410) und dem beweglichen Teil (150, 250, 450), wobei der bewegliche Teil (150, 250, 450) elektrische Anschlussmittel (156, 256, 456) umfasst; die dazu gedacht sind, mit ergänzenden elektrischen Anschlussmitteln des Geräts (300) in Eingriff gebracht zu werden, wobei die Verbindungsmittel (131, 132, 231, 232, 430, 431, 432) derart angeordnet sind, dass der bewegliche Teil (150, 250, 450) im Verhältnis zu dem feststehenden Teil (110, 210, 410) zwischen einer offenen Position, die es ermöglicht, das Gerät (300) an dem feststehenden Teil (110, 210, 410) zu befestigen, und einer geschlossenen Position verstellbar ist, wobei das Verstellen des beweglichen Teils (150, 250, 450) von der offenen Position in die geschlossene Position den Eingriff der elektrischen Anschlussmittel des beweglichen Teils und des Geräts verursacht.

2. Trägerelement nach Anspruch 1, wobei die Verbindungsmittel (131, 132, 231, 232, 430, 431, 432) zwischen dem feststehenden Teil (110, 210, 410) und dem beweglichen Teil (150, 250, 450) Mittel zum Führen des feststehenden Teils (110, 210, 410) im Verhältnis zu dem beweglichen Teil (150, 250, 450) umfassen.

3. Trägerelement nach Anspruch 2, wobei die Führungsmittel geradlinig sind.

4. Trägerelement nach einem der Ansprüche 2 oder 3, wobei die Führungsmittel mindestens eine Schiene umfassen.

5. Trägerelement nach einem der Ansprüche 2 oder 3, wobei die Führungsmittel mindestens einen Führungsfinger (430, 431, 432) umfassen, der dazu geeignet ist, mit einer Führungsöffnung (330, 331, 332) zusammenzuwirken.

6. Trägerelement nach einem der vorhergehenden Ansprüche, wobei die Verbindungsmittel (131, 132, 231, 232, 430, 431, 432) zwischen dem feststehenden Teil (110, 210, 410) und dem beweglichen Teil (150, 250, 450) dazu geeignet sind, eine Gleitbewegung des beweglichen Teils (150, 250, 450) auf dem feststehenden Teil (110, 210, 410) zu ermöglichen.

7. Trägerelement nach einem der vorhergehenden Ansprüche, wobei die elektrischen Anschlussmittel (156, 256, 456) des beweglichen Teils (150, 250, 450) Mittel (158, 258, 458) zum Führen der Anschlussmittel des Geräts (300), wenn sie in Eingriff gebracht werden, umfassen.

8. Trägerelement nach einem der vorhergehenden Ansprüche, wobei der feststehende Teil (110, 210) Blöcke (113, 114, 115, 116, 213, 214, 215, 216, 413, 414, 415, 416) zum Positionieren des Geräts (300) auf dem feststehenden Teil (110, 210, 410) umfasst, auf denen das Gerät (300) zur Anlage kommen kann.

9. Trägerelement nach Anspruch 8, wobei das Gerät (300) durch Schrauben (323, 324, 325, 326) auf den Blöcken (113, 114, 115, 116, 213, 214, 215, 216, 413, 414, 415, 416) an Ort und Stelle verriegelt wird.

10. Trägerelement nach einem der vorhergehenden Ansprüche, wobei der feststehende Teil (110, 210, 410) Stifte (123, 126, 223, 226, 423, 426) umfasst, die dazu gedacht sind, in Öffnungen des Geräts (300) eingefügt zu werden, um das Gerät (300) auf dem Trägerelement (100, 200, 400) zu positionieren.

11. Trägerelement nach einem der vorhergehenden Ansprüche, umfassend mindestens einen Arm (161, 162, 261, 262, 461, 462), der dazu geeignet ist, betätigt zu werden, um durch Hebelwirkung die Verstellung des beweglichen Teils (150, 250, 450) im Verhältnis zu dem feststehenden Teil (110, 210, 410) mit sich zu ziehen.

12. Trägerelement nach Anspruch 11, umfassend eine erste Achse (164, 264) und ein zweite Achse (165, 265), wobei der Arm (161, 162, 261, 262) dazu geeignet ist, um im Verhältnis zu dem feststehenden Teil (110, 210) oder dem Gerät (300) über die erste Achse (164, 264) drehbar angebracht zu werden, und dazu geeignet ist, um im Verhältnis zu dem beweglichen Teil (150, 250) über die zweite Achse (165, 265) drehbar angebracht zu werden.

13. Trägerelement nach Anspruch 12, wobei die erste Achse (164, 264) dazu geeignet ist, im Verhältnis zu dem feststehenden Teil (110, 210) oder im Verhältnis zu dem Gerät (300) zu gleiten.

14. Trägerelement nach Anspruch 13, wobei der feststehende Teil (110) einen Einschnitt oder eine Öffnung (119, 120, 219, 220) umfasst, in dem der die erste Achse (164) gleiten kann.

15. Trägerelement nach Anspruch 11, umfassend einen Einschnitt (469, 470), der dazu geeignet ist, einen Stift (364) des Geräts (300) aufzunehmen, und eine Drehachse (465), wobei der Arm (461, 462) dazu geeignet ist, im Verhältnis zu dem feststehenden Teil (410) oder dem Gerät (300) über den Stift (364), der in dem Einschnitt (469, 470) aufgenommen wird, drehbar angebracht zu werden, und dazu geeignet ist, im Verhältnis zu dem beweglichen Teil (450) über die Drehachse (465) drehbar angebracht zu werden.

16. Trägerelement nach Anspruch 15, wobei der Einschnitt (469, 470) eine Nockenfläche aufweist, die dazu geeignet ist, damit der Stift auf der Nockenfläche gleitet, wenn der Arm (461, 462) drehbar mitgenommen wird.

17. Trägerelement nach einem der Ansprüche 11 bis 16, wobei der Arm (261, 262, 461, 462) dauerhaft auf einem der feststehenden (210, 410) oder beweglichen (250, 450) Teile angebracht ist.

18. Trägerelement nach einem der Ansprüche 11 bis 16, wobei der Arm (161, 162) abnehmbar auf einem der feststehenden (110) oder beweglichen (150) Teile angebracht ist, so dass er abgenommen werden kann, wenn der bewegliche Teil (150) sich in der geschlossenen Position befindet.

19. Trägerelement nach einem der vorhergehenden Ansprüche, wobei der feststehende Teil (410) und der bewegliche Teil (450) sich teilen können, so dass der bewegliche Teil (450) von dem feststehenden Teil (410) getrennt werden kann, damit das Gerät auf dem feststehenden Teil (410) angeordnet werden kann.

20. Trägerelement nach einem der vorhergehenden Ansprüche, umfassend Mittel (137, 138, 237, 238, 437) zum Verriegeln des beweglichen Teils (150, 250, 450) auf dem feststehenden Teil (110, 210, 410) in der geschlossenen Position.

21. Verfahren zum Befestigen eines Geräts an Bord (300) eines Luftfahrzeugs, unter Verwendung eines Trägerelements (100, 200, 400) nach einem der Ansprüche 1 bis 20, umfassend folgende Schritte:
- Befestigen des Geräts (300) auf dem feststehenden Teil (110, 210, 410) des Trägerelements (100, 200, 400), während sich der bewegliche Teil (150; 250, 450) in der offenen Position befindet,
- Verstellen des beweglichen Teils (150, 250, 450) im Verhältnis zu dem feststehenden Teil (110, 210, 410) von der offenen Position in die geschlossene Position, um die elektrischen Anschlussmittel (156, 256, 456) des beweglichen Teils (150, 250, 450) und des Geräts (300) in Eingriff zu bringen.

22. Beweglicher Teil (450) für ein Befestigungsträgerelement (400) nach Anspruch 1 für ein Gerät an Bord (300) eines Luftfahrzeugs, wobei der bewegliche Teil (450) elektrische Anschlussmittel (156, 256, 456) umfasst, die dazu gedacht sind, mit ergänzenden elektrischen Anschlussmitteln des Geräts (300) in Eingriff gebracht zu werden, wobei der bewegliche Teil (450) ferner Verbindungsmittel (430, 431, 432) umfasst, die dazu geeignet sind, mit ergänzenden Verbindungsmitteln (330, 331, 332) des Geräts oder eines feststehenden Teils (410) zusammenzuwirken, wobei die Verbindungsmittel (430, 431, 432) derart angeordnet sind, dass der bewegliche Teil (450) im Verhältnis zu dem feststehenden Teil (410) zwischen einer offenen Position, die es ermöglicht, das Gerät (300) an dem feststehenden Teil (410) zu befestigen, und einer geschlossenen Position verstellbar ist, wobei das Verstellen des beweglichen Teils (450) von der offenen Position in die geschlossene Position den Eingriff der elektrischen Anschlussmittel des beweglichen Teils und des Geräts verursacht.
